Europäisches Patentamt

European Patent Office

Office européen des brevets

(19)

(11) Publication number: **0 135 821**
A2

# (12) EUROPEAN PATENT APPLICATION

(21) Application number: **84110137.1**

(22) Date of filing: **24.08.84**

(51) Int. Cl.⁴: **G 11 C 5/06**

(30) Priority: **02.09.83 US 528817**

(43) Date of publication of application: **03.04.85**
**Bulletin 85/14**

(84) Designated Contracting States: **BE DE FR**

(71) Applicant: **WANG LABORATORIES INC., One Industrial Avenue, Lowell, MA 01851 (US)**

(72) Inventor: **Clayton, James Elliott, 7 Wheelwright Circle RFD 2, Londonderry, NH 03053 (US)**

(74) Representative: **Behrens, Dieter, Dr.-Ing. et al, Patentanwälte WUESTHOFF-V. PECHMANN-BEHRENS-GOETZ Schweigerstrasse 2, D-8000 München 90 (DE)**

(54) **Memory module.**

(57) A memory module to and from which multibit binary words are stored and read out. Each multibit binary word comprises a standard word size and another memory bit that may be used for purposes such as parity checking. The modules may be mounted on a printed circuit mother board from which power, control signals and binary words are applied to and taken from the module.

Description:

Memory Module

The present invention is concerned with a memory module with a plurality of memory chips arranged on mounting means. Multibit binary words are stored and read out. Each multibit binary word comprises a standard byte size and one or more other memory bits that may be used for purposes such as parity checking. The modules may be mounted on a printed circuit mother board from which power, control signals and binary words are applied to and taken from the module.

It is an object of the invention to provide a memory module with memory components having their power, control, input/output and other access leads interconnected so that there is only one set of these leads available at terminals of the module. Especially the number of terminals of the module should be reduced and the information density should be increased over previous circuit assemblies.

A solution of these problems is characterized in the claims.

The present invention is a memory module on which a plurality of memory components each storing or reading one binary bit at a time have their power, control, input/output and other access leads interconnected so there is only one set of these leads available at terminals of the module. A first plurality of these memories provide for one binary word being input or output to the memory module at a time. In addition, it is added another individual memory intended for purposes such as parity checking and error correction. This additional memory has its power and control leads interconnected with the other memories within the module, but has separate input/output lead(s) and column address select leads to enable independent accessing or addressing of the parity memory.

The invention will be understood on reading the following detailed description in conjuction with the drawing in which:

Fig. 1 is an electrical block diagram of the novel memory module; and

Fig. 2 is a mechanical layout drawing of the memory module.

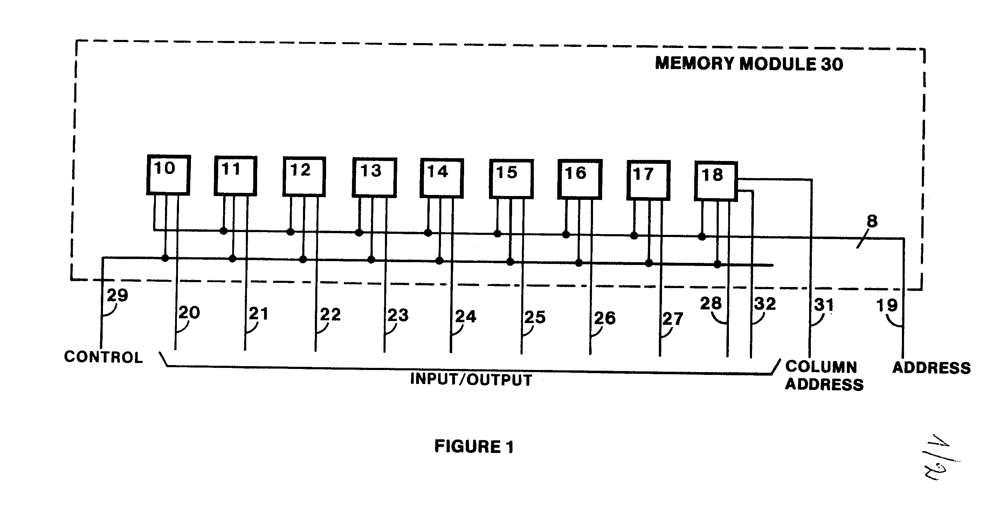

In Figure 1 is seen the electrical block diagram of the invention. In one embodiment of the invention, the embodiment shown in Fig. 1, eight individual memory chips 10-17, each capable of storing a zero or a one binary bit at each memory location, are accessed by a multi-bit address applied to address leads 19 which comprises eight leads. With this embodiment of the invention, single input/output leads 20-27 are provided respectively to each of memory chips 10-17 to provide a total of eight input/output leads making up an eight bit binary word. Control lead 29 connected to one input of each of memory chips 10-17 on the module 30 indicates whether a read or write operation is be performed at the location identified by the address present on the eight address leads 19 which are interconnected to the addressing inputs of each of chips 10-17.

In a manner well known in the art the concurrent addressing
and control of chips 10-17 which are connected in parallel
permits an eight bit byte or binary word to be stored in
or read out of memory chips 10-17 for each read or write
operation.
In accordance with the preferred embodiment of the
invention it is provided an extra memory chip 18 similarly
connected in parallel with memory chips 10-17, the read/
write control leads of which are interconnected with the
control leads 29 connected to memory chips 10-17 with the
exception of the column address select lead 31. Memory
chip 18 has a data input lead 28 and a separate data
output lead 32 as distinguished from memory chips 10-17
which respectively use common input/output data leads 20-27
for both data input and output. A total of ten input/output
data leads 20-28 and 32 are therefore provided on the edge
of the memory module 30 as shown and eight bit binary
words plus and extra ninth bit for functions such as parity
checking are stored in or read out of the memory module 30.
A separate column address select lead 31 is provided for
memory chip 18 to enable independent operation for the
parity function.

When it is desired to store a binary word made up of an
eight bit byte/word with a ninth parity bit in a specific
address location in memory chips 10-17 and 18, the binary
bits are applied to terminals on the edge of memory module 30
which are connected to common input/output leads 20-27
and to input lead 28. Each of the nine binary bits is
thereby applied to the input respectively of memory chips
10-18. A signal is then applied to control lead 29 at a terminal on the edge of memory module 30, which control lead 29 is connected to the read/write control input of chips 10-18. Finally, a multibit binary address is applied to the multiple address leads 19 also on the edge of memory module 30, which addressing leads are connected to the addressing inputs of each of memory chips 10-18. In response to all the above signals applied to the appropriate terminals of memory module 30, the binary word on input/output leads 20-27 and the extra binary bit on input lead 28 are stored respectively in memory chips 10-17 and 18 at the address indicated by the binary number on address leads 19.

Similarly, when it is desired to read a binary word out of memory module 30, a read signal is applied to read/write control lead 29 and a binary address is applied to address leads 19. In response thereto, the binary word stored in memory module 30 at the indicated address is read out of memory chips 10-17 and 18 respectively onto input/output leads 20-27 and output lead 32.

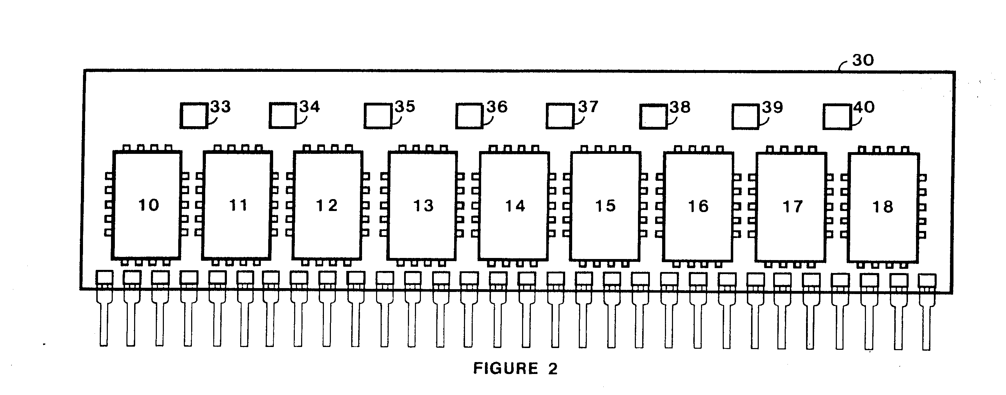

Referring to Figure 2, there is shown a physical layout of the memory module 30. The nine memory chips 10-18 are mounted on a substrate 31 that may be printed circuit board or ceramic. The memory chips 10-18 may be dynamic RAMs (D-RAM) advantageously packaged in small plastic leaded chip carriers. Also mounted on the substrate of module 30 are small ceramic decoupling capacitors 33-40, having a value between 0,1 and 0,22 µfd, and connected between each of memory chips 10-18 to suppress transient voltage spikes. By using the small D-RAMs and small capacitors, module 30 may have physical dimensions in the order of three-quarter inch by three inches while providing large memory capacity. Sixty-four thousand words on the module are presently possible and two hundred fifty-six thousand bytes are feasible with the physical dimensions of module 30 only being slightly larger.

With the invention the input, output and control of the memory elements 10-18 on module 30 may be accomplished via only thirty terminals on the edge of the module. Use of module 30 in lieu of memory chips in conventional dual in line terminal packages normally mounted in rows and columns on a printed circuit board enables an eight-fold density increase over previous circuit assembly technology.

In addition, by having an extra memory chip parity may be checked. By having separate control of the extra memory chip a system designer has more flexibility in designing parity operation.

While what has been described hereinabove is the preferred embodiment of the invention, it will be obious to those skilled in the art that numerous changes may be made without departing from the spirit or scope of the invention. More than one bit may be used for parity checking or other purposes. In addition, rather than using discrete memory chips, the unpackaged dies may be mounted on a substrate to implement the invention in a hybrid integrated circuit package or in a large scale integrated circuit package.

Claims:

1.     A memory module comprising a plurality of memory chips arranged on mounting means c h a r a c t e r i z e d   in that control inputs (19, 29) of a first plurality of memory chips are interconnected by the mounting means so that one word of digital information may be input or output from said memory chips at a time, said mounting means (30) including terminal means (FIG. 2) for providing access to said input, output (20-27) and control inputs (19, 29) of said first plurality of memory chips to thereby enable reading and writing said words of digital information into and out of said first plurality of memory chips, and an auxiliary memory chip (18) for storing error correction and detection information, said auxiliary memory chip (18) being mounted on said mounting means (30) and having its control inputs interconnected with the control inputs of said first plurality of memory chips (10-17).

2.     A memory module comprising a plurality of memory chips arranged on mounting means c h a r a c t e r i z e d   in that a first plurality of data memory chips (10-17) each having data input/output (20-27), read/write (29) and addressing control inputs (19), mounting means (30) for mounting said first plurality of memory chips (10-17) and interconnecting the read/write (29) and addressing (19) control inputs of said first plurality of memory chips (10-17) so that one word of digital information may be written into or read out from said first plurality of memory chips (10-17) at a time, said mounting means (30) including terminal means for providing connection to said (input/output (27), read/write (29) and addressing control (19) inputs of each of said first plurality of memory chips (10-17) to thereby enable reading and writing said words of digital information into and out of said first plurality of memory chips (10-17) and auxiliary memory means (18) for storing information ancilliary to said words of digital information, said auxiliary memory means (18) being mounted on said mounting means (30) and having read/write inputs that are interconnected with the read/write inputs of said first plurality of memory chips (10-17), and said auxiliary memory means (18) having an addressing control input (31) that is accessable via said terminal means to provide flexibility in reading and writing said ancilliary information.

3.    The invention in accordance with claim 2 c h a r a c t e r i z e d  in that said auxiliary memory means (18) comprises an auxiliary memory chip for storing error correction and detection information which may written into or read out of said auxiliary memory chip (18) at times other than when said words of digital information are written into or read out of said first plurality of memory chips (10-17) to thereby facilitate said error detection and correction operation.

FIGURE 1

**FIGURE 2**